(19) Europäisches Patentamt
European Patent Office
Office européen des brevets

(11) Publication number: **0 032 017**
**B1**

(12) # EUROPEAN PATENT SPECIFICATION

(45) Date of publication of patent specification: **28.03.84**

(51) Int. Cl.$^3$: **H 03 K 5/02,**
H 03 K 19/096

(21) Application number: **80304535.0**

(22) Date of filing: **16.12.80**

(54) **Bootstrap circuit.**

(30) Priority: **19.12.79 JP 165013/79**

(43) Date of publication of application:
**15.07.81 Bulletin 81/28**

(45) Publication of the grant of the patent:
**28.03.84 Bulletin 84/13**

(84) Designated Contracting States:
**DE FR GB NL**

(56) References cited:
**EP - A - 0 003 963**
**US - A - 3 774 055**
**US - A - 3 898 479**
**US - A - 4 061 933**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshihiro**
**20-5-9-301, Utsukushigaoka 1-chome Midori-ku**
**Yokohama-shi Kanagawa 227 (JP)**

(74) Representative: **Abbott, Leonard Charles et al,**
**GILL JENNINGS & EVERY 53-64 Chancery Lane**
**London WC2A 1HN (GB)**

**EP 0 032 017 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Bootstrap circuit

The present invention relates to a bootstrap circuit, and more specifically to a bootstrap circuit which is used in a MOS (metal oxide semiconductor) integrated circuit such as a circuit for generating clock pulses to drive word lines.

A bootstrap circuit used in a MOS integrated circuit is constructed as mentioned below as has been disclosed, for example, in the United States Patent No. 3,774,055. Namely, a load MOS transistor and a drive MOS transistor are connected in series between a high-potential source and a low-potential source thereby forming an inverter, and a capacitor is connected between a point at which the above-mentioned two transistors are connected together and the gate of the above-mentioned load transistor. Further, a circuit for electrically charging the capacitor and a circuit for discharging the capacitor are connected to the side where the capacitor is connected to the gate of the load transistor. The discharge circuit consists of a MOS transistor that is connected between the side where the capacitor is connected to the gate of the load transistor and the above-mentioned low-potential source. The discharge circuit is rendered conductive to discharge the above-mentioned capacitor when a reset signal is applied to the gate of the MOS transistor.

In the bootstrap circuit constructed as mentioned above, the potential at a discharging point of the capacitor before the discharge takes place is higher than the potential of the high-potential source. Therefore, a high voltage is impressed between the drain and the source of the MOS transistor in the discharge circuit during the initial stage of the discharge, while the potential of the reset signal applied to the gate is smaller than that of the high-potential source. Consequently, the MOS transistor operates in a deeply saturated region. When the MOS transistor operates in a deeply saturated region, in general, hot electrons of high energy are generated in large amounts and are captured by the gate oxide film, causing the threshold voltage to undergo variation. Even putting aside the generation of hot electrons, the flow of current in the deeply saturated region is in the state of punch-through or in the state where the element is to be just broken down, and is never desirable.

The object of the invention is to provide a bootstrap circuit which is free from the defects inherent in the conventional counterparts, and which eliminates the problem of variation in the threshold voltage of the MOS transistor in the discharge circuit and prevents the MOS transistor in the discharge circuit from being broken down.

The present invention consists in a bootstrap circuit in which a load MOS transistor and a drive MOS transistor are connected in series between a high-potential source and a low-potential source to form an inverter, a capacitor is connected at one of its terminals to the point at which the load and drive transistors are connected together, and at the other of its terminals to a circuit for charging the capacitor and a circuit for discharging the capacitor, the circuit for discharging the capacitor being connected between the capacitor and the low-potential source and comprising a first MOS transistor which is rendered conductive upon receipt of a reset signal, the bootstrap circuit characterized in that the discharging circuit further comprises a second MOS transistor connected between the first MOS transistor and the capacitor and whose gate is supplied with a high voltage relative to the low-potential source.

Further features and advantages of the present invention will become apparent from the ensuing description of a preferred embodiment of the invention with reference to the accompanying drawings, in which:

Figure 1 is a diagram illustrating a circuit which generates a signal for driving word lines, employing a conventional bootstrap circuit;

Figure 2 is a diagram illustrating the operation waveforms at major portions of the circuit of Figure 1;

Figure 3 is a diagram illustrating the operation characteristics of a resetting transistor in the circuit of Figure 1;

Figure 4 is a block diagram of a bootstrap circuit according to an embodiment of the present invention;

Figure 5 is a diagram illustrating a circuit which generates a signal for driving word lines, employing a bootstrap circuit according to the present invention;

Figure 6 is a diagram illustrating the operation waveforms at major portions of the circuit of Figure 5; and

Figure 7 is a diagram illustrating the operation characteristics of a resetting transistor in the circuit of Figure 5.

A bootstrap circuit is usually now used only in the circuits of MOS transistors. Figure 1 illustrates a circuit which generates a signal WD to drive word lines, in which transistors $Q_6$, $Q_7$, $Q_8$, $Q_{10}$ and a capacitor $Q_9$ form a conventionally employed bootstrap circuit. A signal $N_3$ for driving the transistor $Q_6$ of the bootstrap circuit is prepared by a circuit which consists of MOS transistors $Q_1$ to $Q_5$. The transistors $Q_1$ and $Q_2$ constitute an inverter which operates when clock pulses $\phi_1$ and $\phi_2$ of opposite phases are applied thereto, and the transistors $Q_3$ and $Q_4$ constitute an inverter which operates when the clock pulse $\phi_2$ and an output $N_1$ of the preceding stage are applied thereto. The transistor $Q_5$ is connected between an output

terminal $N_2$ of the inverter of the second stage and the gate $N_3$ of the transistor $Q_6$.

Referring to Figure 1, the bootstrap circuit consists, for example, of N-channel MOS transistors $Q_6$, $Q_7$, $Q_8$ and $Q_{10}$ and capacitor $Q_9$, wherein the load transistor $Q_8$ and the drive transistor $Q_{10}$ constitute an inverter. A MOS capacitor $Q_9$ is connected between an output terminal $N_5$ of the above inverter and the gate of the transistor $Q_8$, a circuit for charging the capacitor $Q_9$ and which includes the transistor $Q_6$ is connected to the side (connection point $N_4$) where the capacitor is connected to the gate of the transistor $Q_8$, and a circuit for discharging the capacitor $Q_9$ and which includes transistor $Q_7$ is also connected to the side (connection point $N_4$) where the capacitor is connected to the gate of the transistor $Q_8$. The other end of the transistor $Q_7$ (source of the transistor $Q_7$, since the transistors employed here are all assumed to be of the N-channel type) is connected to a low-potential source $V_{SS}$. When the signals $N_3$, $N_2$ of the high level are applied to render the transistors $Q_6$, $Q_{10}$ conductive, and when the clock pulse $\phi_1$ of the H ($V_{CC}$) level is applied, the capacitor $Q_9$ is electrically charged through a path

$$Q_6—Q_9—Q_{10}—V_{SS},$$

whereby the potential at the point $N_4$ effects the bootstrapping for the transistor $Q_6$ and acquires the potential of the clock pulse $\phi_1$. When the signals $N_3$, $N_2$ assume the low level under this state, the output terminal $N_5$ is electrically disconnected from the low-potential source $V_{SS}$, and is driven to the high-potential source $V_{CC}$ by the transistor $Q_8$. Therefore, the potential at the point $N_4$ is raised by the electric charge of the capacitor $Q_9$ to be greater than that of the high-potential source $V_{CC}$. The potential at the point $N_4$ usually becomes 1.7 to 1.8 times greater than that of the high-potential source $V_{CC}$. Therefore, the load transistor $Q_8$ is completely turned on, and the voltage of the power supply $V_{CC}$ directly appears at the output terminal $N_5$ without being affected by the threshold voltage $V_{th}$ of the transistor $Q_8$. When the transistor $Q_8$ is simply turned on without utilizing the bootstrapping function, the output level at the output terminal $N_5$ is simply $V_{CC}—V_{th}$ as is widely known, and is not quite sufficient for driving the word lines of the semiconductor memories that require a high voltage.

In the circuit of Figure 1, a signal WD for driving the word lines is taken out from a connection point between a MOS transistor $Q_{11}$ of which the gate is controlled by the potential at the point $N_4$ like the transistor $Q_8$ and a transistor $Q_{12}$ of which the gate is controlled by the potential at the point $N_2$ like the transistor $Q_{10}$.

The operation of the circuit will now be explained below with reference to the waveforms of Figure 2. In the initial stage in which the clock pulse $\phi_1$ is of the low level ($V_{SS}$) and the clock pulse $\phi_2$ is of the high level ($V_{CC}$), the transistors $Q_2$ and $Q_3$ are conductive so that the potential at the point $N_1$ is of the low level and the potential at the point $N_2$ is of the high level ($V_{cc}—V_{th}$), and the transistor $Q_5$ is conductive so that the potential at the point $N_3$ is raised to $V_{CC}—V_{th}$. When the clock pulse $\phi_1$ is changed into the high level and the clock pulse $\phi_2$ into the low level, the transistors $Q_1$ and $Q_4$ are rendered conductive, whereby the potential at the point $N_1$ is raised and the potential at the point $N_2$ is lowered. Hence, the transistor $Q_5$ is rendered non-conductive. In this case, since the clock pulse $\phi_1$ assumes the high level, the level at the point $N_3$ is raised to become greater than $V_{CC}+V_{th}$, and the transistor $Q_6$ is completely rendered conductive (without being affected by the drop in the threshold voltage $V_{th}$). Further, since the transistor $Q_{10}$ remains conductive for a short period of time during which the potential at the point $N_2$ is greater than $V_{th}$, of $Q_{10}$ an electric current flows through a path

$$\phi_1(V_{CC})—Q_6—N_4—Q_9—Q_{10}—V_{SS}$$

so that the capacitor $Q_9$ is electrically charged until the potential at the point $N_4$ reaches $V_{CC}$. Then, as the potential at the point $N_2$ gradually decreases to become smaller than $V_{th}$, the transistor $Q_{10}$ is rendered non-conductive and the potential at the point $N_4$ is raised to be greater than $V_{CC}$ (ideally $2V_{CC}$) by the electric charge of the capacitor $Q_9$. Consequently, the potential at the point $N_5$ becomes $V_{CC}$, and the clock pulse WD assumes the potential $V_{CC}$(H). Thereafter, as the clock pulses $\phi_1$ and $\phi_2$ are inverted, the transistor $Q_7$ is rendered conductive by the clock pulse $\phi_2$ of the high level, and the electric charge accumulated in the capacitor $Q_9$ is discharged as mentioned above through a path

$$Q_9—N_4—Q_7—V_{SS}.$$

Namely, the bootstrap circuit is reset.

In the thus reset bootstrap circuit, the potential at the point $N_4$ before the discharge in a reset period ($t_1$ in Figure 2) takes place is greater than the potential $V_{CC}$ as mentioned earlier. During the initial stage of the discharge, therefore, a high voltage is applied between the drain and the source of the transistor $Q_7$, while the gate voltage $\phi_2$ is lower than $V_{CC}$. Consequently, the transistor $Q_7$ operates in a deeply saturated region. Figure 3 illustrates changes in the transistor characteristics during the discharge step. Namely, Figure 3 shows the $V_D—I_D$ characteristics $C_1$ of the transistor $Q_7$ with the gate voltage as a parameter, and $C_2$ represents the locus of an operation region in which the transistor $Q_7$ passes when the electric charge is discharge at the point $N_4$. When the MOS transistor operates in a deeply saturated region, in general, hot electrons of high energy are generated in large amounts and are captured by

the gate oxide film, causing the threshold voltage $V_{th}$ to undergo variation. Even putting aside the generation of hot electrons and hot holes, the flow of current in the deeply saturated region is in the state of punch-through or in the state where the element is to be just broken down, and is never desirable.

The bootstrap circuit having a discharge circuit in accordance with the invention is characterized by the provision of a second MOS transistor which is connected between the first MOS transistor of the discharge circuit and the capacitor, the gate of the second MOS transistor being connected to a high-potential source. An embodiment of the present invention is described below in detail with reference to Figures 4 to 7.

Figure 4 illustrates an embodiment of the present invention in which a MOS transistor $Q_7'$ is added to the reset circuit, thus differing from the circuit of Figure 1. Namely, the first and second MOS transistors $Q_7$ and $Q_7'$ are connected in series between the point $N_4$ and the low-potential source $V_{SS}$, a reset signal $\phi_2$ is applied to the gate of the first transistor $Q_7$, and the gate of the second transistor $Q_7'$ is connected to the high-potential source $V_{CC}$. Accordingly, the potential at the point $N_4$ is divided by the transistors $Q_7$ and $Q_7'$, and the potential at a point $N_4'$ on the side of the drain of the transistor $Q_7$ becomes considerably smaller than the potential at the point $N_4$. Concretely speaking, since the gate of the transistor $Q_7'$ is connected to the high-potential source $V_{CC}$, the potential at the point $N_4'$ does not become greater than $V_{CC}$—$V_{th}$. Hence, the transistor operates less in the deeply saturated region, and the effect of hot electrons is reduced like other transistors $Q_8$, $Q_{10}$. In the case of the circuit of Figure 1, even if the effect by the hot electrons is disregarded, the drain and source of the transistor $Q_7$ are impressed with a voltage which is so great as to almost break it down; such a high voltage is not desirable as it may destroy the element. According to the circuit of the present invention, on the other hand, a reduced voltage is applied across the drain and the source, and there is little chance that the transistor $Q_7$ may be destroyed. The transistor $Q_7'$ is served with a differential voltage between the point $N_4$ and the point $N_4'$. The differential voltage, however, is smaller than $V_{CC}$, and fewer hot electrons are generated in the transistor $Q_7'$, so this element is not destroyed either. It is not desirable to connect the gate of the transistor $Q_7'$ to the point $N_4$, because it would only reduce the potential at the point $N_4'$ by a threshold voltage $V_{th}$ relative to the potential at the point $N_4$. If the gate of the transistor $Q_7'$ were connected to the point $N_4$, furthermore, there would arise a problem specific to the bootstrap circuit, that the gate capacity of the transistor $Q_8$ and the gate capacity of the transistor $Q_7'$ become loads as viewed from the capacitor $Q_9$. Therefore, the potential at the connection point $N_4$ would not rise when the bootstrap operates, the mutual conductance gm of the transistor $Q_8$ would decrease, and it would be difficult to increase the output level at the output terminal $N_5$. None of the above-mentioned problems, however, develop when the gate of the transistor $Q_7'$ is connected to the high-potential source $V_{CC}$.

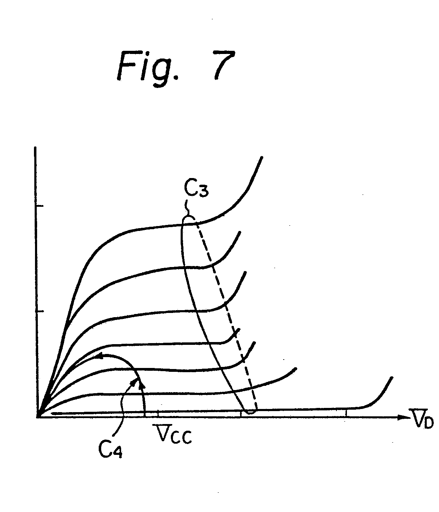

Figure 5 shows a circuit which generates a signal WD for driving word lines according to the present invention. The provision of the transistor $Q_7'$ like that of Figure 4 makes the circuit of Figure 5 different from the circuit of Figure 1. The operation of this circuit will be easily understood from Figure 5 and figure 1, and is not mentioned here. Figure 6 illustrates voltage waveforms at each portion of the circuit, and Figure 7 illustrates the locus $C_4$ of the operation region where the transistors $Q_7$, $Q_7'$ pass when the electric charge is discharged at the point $N_4$. Symbol $C_3$ represents $V_D$—$I_D$ characteristics of the transistors $Q_7$, $Q_7'$ with the gate voltage as a parameter. Referring to Figure 6, a peak value at the point $N_4'$ is nearly equal to $V_{CC}$—$V_{th}$, which is about one-half the value at the point $N_4$. Therefore, as represented by a curve $C_4$ in Figure 7, the drain voltage $V_D$ at which the transistors $Q_7$, $Q_7'$ start to discharge is about one-half the initial value which is represented by the curve $C_2$ in Figure 3.

According to the present invention as mentioned above, a high voltage which is raised by the bootstrap circuit is not directly applied to between the drain and the source of the MOS transistor which constitutes a reset circuit in the bootstrap circuit. Therefore, the transistor is not destroyed, and hot electrons of high energy are not generated in large amounts to vary the threshold voltage $V_{th}$.

## Claims

1. A bootstrap circuit in which a load MOS transistor ($Q_8$) and a drive MOS transistor ($Q_{10}$) are connected in series between a high-potential source ($V_{CC}$) and low-potential source ($V_{SS}$) to form an inverter, a capacitor ($Q_9$) is connected at one of its terminals to the point ($N_5$) at which the load and drive transistors are connected together, and at the other of its terminals to a circuit ($\phi_1$, $Q_6$) for charging the capacitor and a circuit for discharging the capacitor, the circuit for discharging the capacitor being connected between the capacitor and the low-potential source and comprising a first MOS transistor ($Q_7$) which is rendered conductive upon receipt of a reset signal ($\phi_2$), the bootstrap circuit characterized in that the discharging circuit further comprises a second MOS transistor ($Q_7'$) connected between the first MOS transistor and the capacitor and whose gate is supplied with a high voltage relative to the low-potential source.

2. A bootstrap circuit according to claim 1, wherein the gate of the second MOS transistor ($Q_7'$) is connected to the high-potential source.

3. A bootstrap circuit according to claim 1 or 2, wherein the gate of the load ($Q_8$) transistor is connected to the said other terminal of the capacitor.

4. A semiconductor integrated circuit which generates an output signal (WD) to drive word lines, comprising a bootstrap circuit according to any preceding claim and a circuit ($Q_1$, $Q_2$, $Q_3$, $Q_4$, $Q_5$), responsive to the set and reset signals ($\phi_1$, $\phi_2$), which generates a signal ($N_3$) to control the passage of a set signal ($\phi_1$) to the capacitor of the bootstrap circuit.

5. A circuit according to claim 4, further comprising a second inverter ($Q_{11}$, $Q_{12}$) connected between the high- and the low-potential sources in parallel with the said inverter ($Q_8$, $Q_{10}$), the second inverter comprising two MOS transistors ($Q_{11}$, $Q_{12}$) whose gates are connected to gates of corresponding transistors ($Q_8$, $Q_{10}$) of the said inverter, and providing the output signal (WD).

**Patentansprüche**

1. Bootstrapschaltung mit einem MOS-Lasttransistor ($Q_8$) und einem MOS-Treibertransistor ($Q_{10}$), welche in Reihe zwischen einer Quelle hohen Potentials (Vcc) und einer Quelle niedrigen Potentials (Vss) geschaltet sind, um einen Inverter zu bilden, einem Kondensator ($Q_9$), welcher mit seinem einen Anschluß an dem Punkt ($N_5$) angeschlossen ist, bei welchem der Lasttransistor und der Treibertransistor gemeinsam angeschlossen sind, und der mit seinem anderen Anschluß an einer Schaltung ($\phi_1$, $Q_6$) angeschlossen ist, um den Kondensator zu laden, und mit einer Schaltung zur Entladung des Kondensators, welche zwischen dem Kondensator und der Quelle tiefen Potentials angeschlossen ist und einen ersten MOS-Transistor ($Q_7$) umfaßt, welcher bei Empfang eines Rückstellsignals ($\phi_2$) leitfähig gemacht wird, dadurch gekennzeichnet, daß die Entladeschaltung ferner einen zweiten MOS-Transistor ($Q'_7$) umfaßt, welcher zwischen dem ersten MOS-Transistor und dem Kondensator verbunden ist und dessen Gate eine relativ zu der Quelle niedrigen Potentials hohe Spannung zugeführt wird.

2. Bootstrapschaltung nach Anspruch 1, bei welcher das Gate des zweiten MOS-Transistors ($Q'_7$) mit einer Quelle hohen Potentials verbunden ist.

3. Bootstrapschaltung nach Anspruch 1 oder 2, bei welcher das Gate des Lasttransistors ($Q_8$) mit dem anderen Anschluß des Kondensators verbunden ist.

4. Integrierte Halbleiterschaltung, welche ein Ausgangssignal (WD) zum Treiben der Wortleitungen erzeugt, mit einer Bootstrapschaltung nach einem der vorhergehenden Ansprüche und einer Schaltung ($Q_1$, $Q_2$, $Q_3$, $Q_4$, $Q_5$), welche auf die Einstell- und Rückstellsignale ($\phi_1$, $\phi_2$) anspricht und welche ein Signal ($N_3$) fur Steuerung des Durchgangs eines Einstellsignals ($\phi_1$) zu dem Kondensator der Bootstrapschaltung erzeugt.

5. Schaltung nach Anspruch 4, gekennzeichnet durch einen zweiten Inverter ($Q_{11}$, $Q_{12}$), welcher zwischen den Quellen hohen Potentials und niedrigen Potentials parallel zu dem genannten Inverter ($Q_8$, $Q_{10}$) angeschlossen ist und MOS-Transistoren ($Q_{11}$, $Q_{12}$) umfaßt, deren Gates mit den Gates der entsprechenden Transistoren ($Q_8$, $Q_{10}$) der genannten Inverter verbunden sind und der das Ausgangssignal (WD) liefert.

**Revendications**

1. Circuit d'amplificateur à contre-réaction dans lequel un transistor MOS de charge ($Q_8$) et un transistor MOS d'attaque ($Q_{10}$) sont connectés en série entre une source de potentiel élevé ($V_{cc}$) et une source de potentiel bas ($V_{ss}$) pour former un inverseur, un condensateur ($Q_9$) étant connecté par l'une de ses bornes au point ($N_5$) auquel les transistors d'attaque et de charge sont connectés ensemble et par l'autre de ses bornes à un circuit ($\phi_1$, $Q_6$) pour charge le condensateur et un circuit pour décharger le condensateur, le circuit de décharge de condensateur étant connecté entre le condensateur et la source de potential bas et comprenant un premier transistor MOS ($Q_7$) qui est rendu conducteur à la réception d'un signal de mise au repos ($\phi_2$), circuit d'amplificateur caractérisé en ce que le circuit de décharge comporte en outre un second transistor MOS ($Q'_7$) connecté entre le premier transistor MOS et le condensateur et dont la grille reçoit une tension haute par rapport à la source de potentiel bas.

2. Circuit d'amplificateur selon la revendication 1, dans lequel la grille du second transistor MOS ($Q'_7$) est connecté à la source de potential élevé.

3. Circuit d'amplificateur selon la revendication 1 ou 2, dans lequel la grille du transistor de charge ($Q_8$) est connectée à la grille de l'autre borne du condensateur.

4. Circuit intégré à semi-conducteurs qui produit un signal de sortie (WD) pour attaquer des lignes de mots, comprenant un circuit d'amplificateur à contre-réaction selon l'une quelconque des revendications précédentes et un circuit ($Q_1$, $Q_2$, $Q_3$, $Q_4$, $Q_5$) réagissant à des signaux de mise en place et de mise au repos ($\phi_1$, $\phi_2$) qui produit un signal ($N_3$) pour commander le passage d'un signal de mise en place ($\phi_1$) vers le condensateur du circuit d'amplificateur.

5. Circuit selon la revendication 4, comprenant en outre un second inverseur ($Q_{11}$, $Q_{12}$) connecté entre les sources de potentiel élevé et de potentiel bas, en parallèle avec ledit

inverseur ($Q_8$, $Q_{10}$), le second inverseur comprenant deux transistors MOS ($Q_{11}$, $Q_{12}$) dont les grilles sont connectées aux grilles des transistors correspondants ($Q_8$, $Q_{10}$) dudit inverseur et produisant le signal de sortie (WD).

Fig. 1

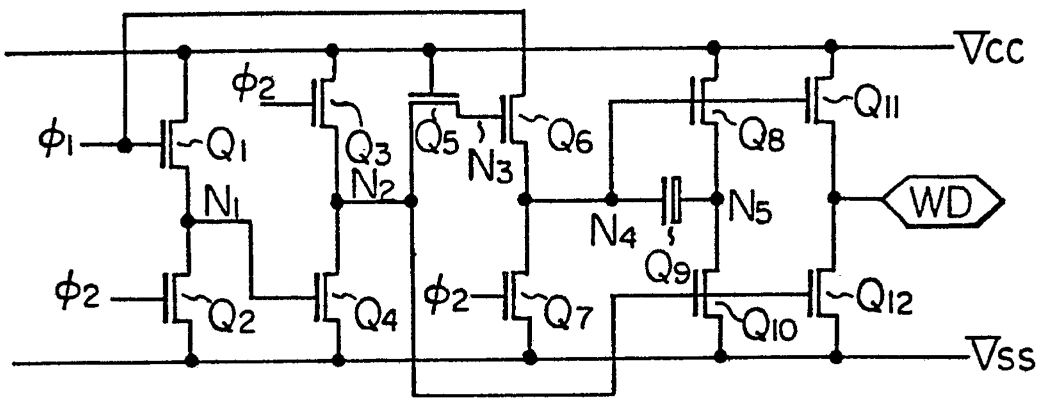

Vcc
φ1
Q1
φ2
Q3
Q5
N3
Q6
Q8
Q11
N1
N2
N4
N5
Q9
WD
φ2
Q2
Q4
φ2
Q7
Q10
Q12
Vss


Fig. 2

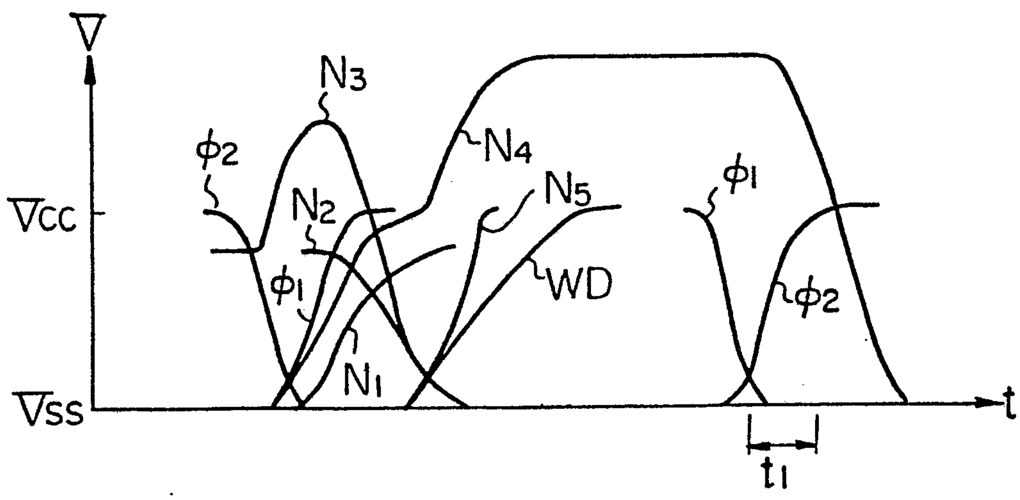

V
Vcc
Vss
N3
φ2
N2
φ1
N1
N4
N5
WD
φ1
φ2
t
t1

*Fig. 3*

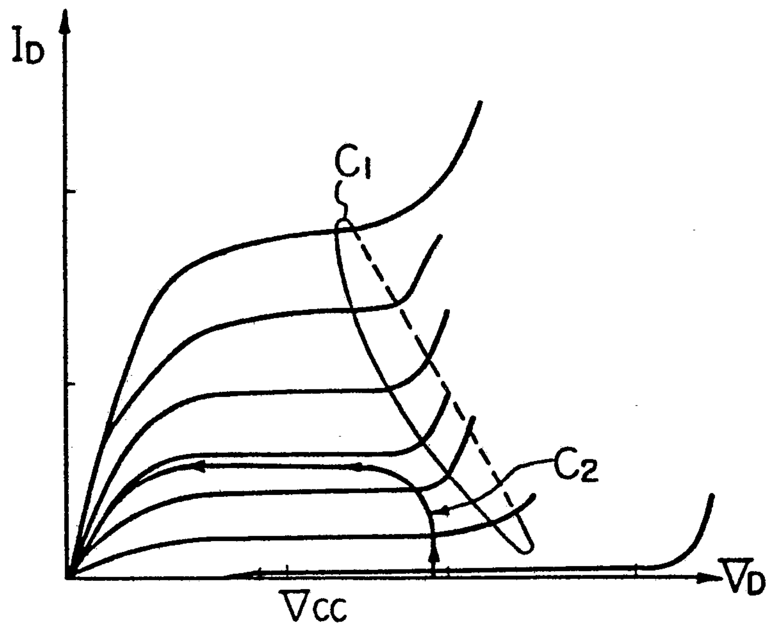


*Fig. 4*

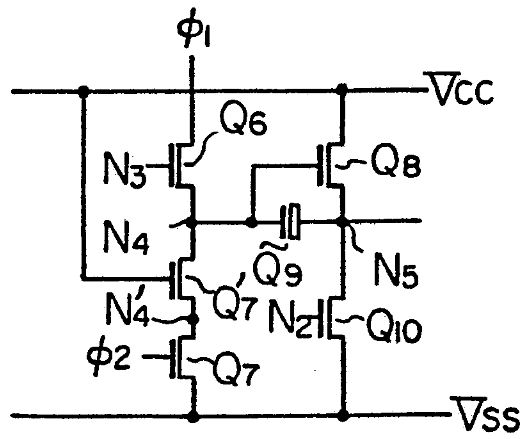

Fig. 5

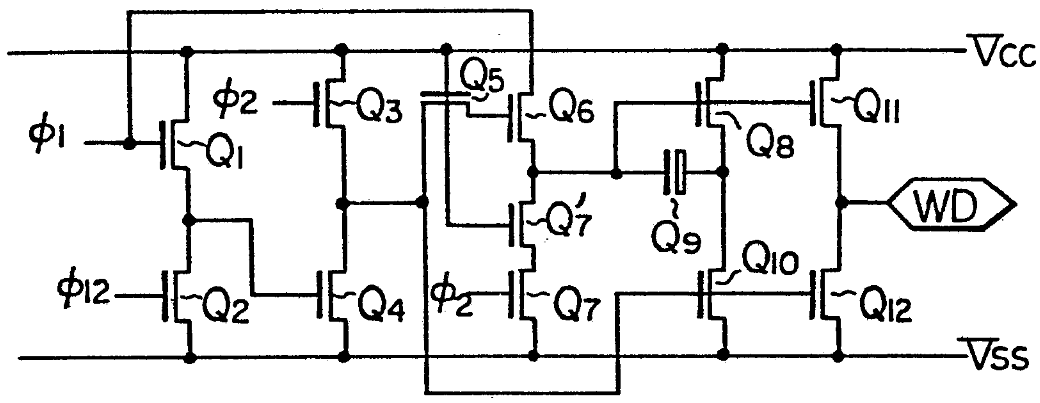
VCC
φ1
Q1
φ2
Q3
Q5
Q6
Q8
Q11
Q7'
Q9
WD
φ12
Q2
Q4
φ2
Q7
Q10
Q12
VSS

Fig. 6

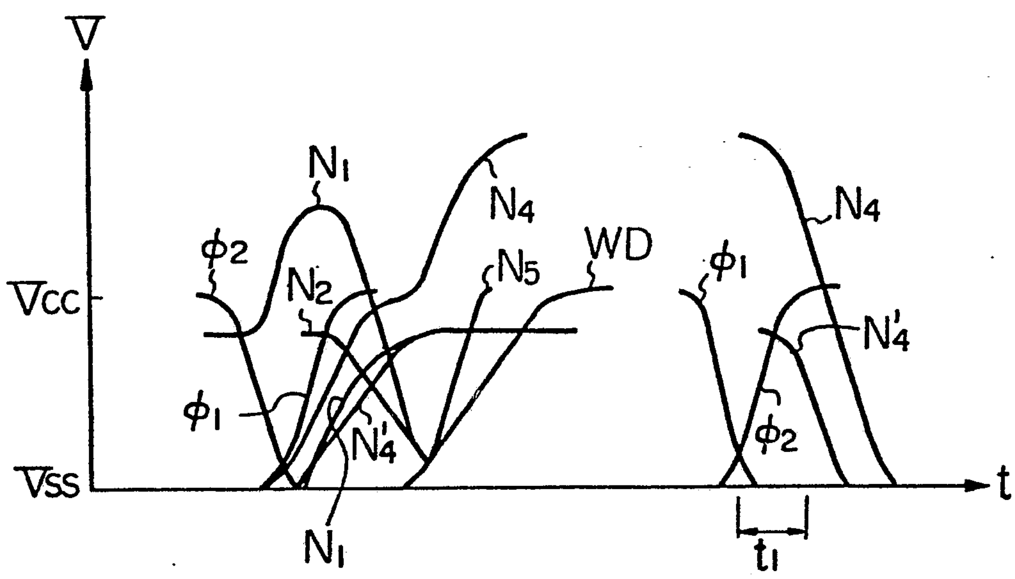
V
N1
N4
φ2
N2
N5
WD
φ1
N4
VCC
N'4
φ1
N'4
φ2
VSS
N1
t1
t

Fig. 7